# EUROPÄISCHE PATENTSCHRIFT

(11) **EP 3 107 211 B1**
(45) Veröffentlichungstag und Bekanntmachung des Hinweises auf die Patenterteilung: **28.11.2018**
(21) Anmeldenummer: 15172565.2
(22) Anmeldetag: 17.06.2015
(51) Int. Cl.: H03K 17/97, H01H 23/30, H01H 23/14, H01H 23/28

(54) **STEUER- UND BEDIENEINHEIT FÜR EINE HUBARBEITSBÜHNE, EINE MOBILE ARBEITSMASCHINE ODER EINE BAUMASCHINE**
CONTROL AND OPERATION UNIT FOR AN ELEVATING WORK PLATFORM, A MOBILE WORKING MACHINE OR A CONSTRUCTION MACHINE
UNITÉ DE COMMANDE POUR UNE PLATE-FORME ÉLÉVATRICE, MACHINE DE TRAVAIL MOBILE OU ENGIN

(43) Veröffentlichungstag der Anmeldung: 21.12.2016
(73) Patentinhaber: MOBA Mobile Automation AG, 65555 Limburg (DE)
(72) Erfinder: Zils, Boris, 65555 Limburg (DE)
(74) Vertreter: Zimmermann, Tankred Klaus

(56) Entgegenhaltungen:
- EP-A2- 1 167 109
- WO-A1-2013/159067
- US-A- 3 265 826
- US-B1- 8 570 126

## Beschreibung

Die vorliegende Erfindung bezieht sich auf das Gebiet von Steuer- und Bedieneinheiten an Hubarbeitsbühnen, an mobilen Arbeitsmaschinen oder an Baumaschinen mit mindestens einer Wippschaltvorrichtung sowie auf eine Hubarbeitsbühne, eine mobile Arbeitsmaschine und eine Baumaschine mit einer derartigen Steuer- und Bedieneinheit.

Steuer- und Bedieneinheiten werden beispielsweise an Hubarbeitsbühnen zum Verfahren eines Arbeitskorbes oder an Baumaschinen zum Verstellen eines Arbeitswerkzeuges verwendet. Dabei sind die Steuer- und Bedieneinheiten in der Regel widrigsten Umweltbedingungen, wie beispielsweise Regen oder Staub sowie extremen Temperaturen, ausgesetzt. Derartige Steuer- und Bedieneinheiten umfassen verschiedene Module, beispielsweise eine Tastatur, einen Joystick und/oder eine Anzeige. Im Tastaturmodul können verschiedene Arten von Schaltern bzw. Schaltvorrichtungen eingesetzt werden, beispielsweise auch Kipp- bzw. Wippschalter oder Wipptaster, die allgemein auch als "Rocker-Switches" bekannt sind.

Im Stand der Technik sind verschiedene Ausgestaltungen von "Rocker-Switches" für Steuer- und Bedieneinheiten an mobilen Arbeitsmaschinen oder Baumaschinen bekannt, welche im Wesentlichen aus einem einzigen kompakten Schaltermodul bestehen. Dieser Aufbau ist nachteilhaft, da im Reparaturfall der komplette Schalter ausgebaut werden muss. Als Schaltelemente werden üblicherweise Mikroschalter oder ähnliche mechanische Schaltelemente verwendet, welche einem hohen Verschleiß unterliegen und somit im Hinblick auf ihre Lebenserwartung nachteilhaft sind. Ferner sind in dem Bereich von Steuer- und Bedieneinheiten an Maschinen auch Rocker-Switches mit Hall-Sensoren bekannt. Die WO 2002/13387 A1 beschreibt eine auf einer Platte aufgeklebte Wippschaltvorrichtung mit einem im Wippschalter integrierten Dauermagneten, welcher bei einer Bewegung des Wippschalters mit bewegt wird. Im Gehäuse des Wippschalters ist ein weiterer Magnet angeordnet, welcher den Wippschalter im nicht-betätigten Zustand in einer definierten Position hält. Unterhalb der Platte ist ferner ein magnetoresistives Element zum Detektieren eines Schaltvorgangs angeordnet.

Rocker-Switches mit Hall-Sensoren sind auch in anderen Einsatzbereichen bekannt, so offenbart beispielsweise die US 4,216,458 A eine Wippschaltvorrichtung mit einem in einem Gehäuse beweglich angeordneten Dauermagneten und einem im unteren Bereich des Gehäuses angeordneten Halleffekt-Sensor. Am Gehäuse ist ein lösbar befestigter und drehbar gelagerter Wippschalter angeordnet, welcher bei Betätigung den Dauermagneten im Gehäuse verschiebt, wodurch der Halleffekt-Sensor einen Schaltvorgang detektiert. Die US 4,868,530 A beschreibt eine Wippschaltvorrichtung mit einem im Wippschalter integrierten Dauermagneten, welcher bei einer Bewegung des Wippschalters mit bewegt wird, sowie zwei magnetoresistive Sensoren zum Detektieren eines Schaltvorgangs, wobei der Wippschalter und die Sensoren in einem Gehäuse angeordnet sind. In einem unteren Bereich des Gehäuses ist ein weiterer Magnet angeordnet. Je nach Anordnung dieses Magneten kann der Wippschalter einen oder zwei stabile Zustände in dem nicht-betätigten Zustand einnehmen.

Der Nachteil bei den aus dem Stand der Technik bekannten Wippschaltvorrichtungen ist darin zu sehen, dass ein definierter und sicherer Schaltzustand nur anhand eines Sensors erkannt werden kann. Auch bei der aus der US 4,868,530 A bekannten Wippschaltvorrichtung mit zwei magnetoresistiven Sensoren ist dies der Fall, da hier immer nur von einem der beiden Sensoren ein definiertes Magnetfeld detektiert werden kann. Eine sichere und redundante Auswertung eines Schaltvorgangs beim Einsatz in sicherheitsrelevanten Anwendungen, beispielsweise im Bereich von Hubarbeitsbühnen, ist bei den aus dem Stand der Technik bekannten Wippschaltvorrichtungen mit Halleffekt-Sensoren nicht gegeben. Ferner ist nachteilhaft, dass ein magnetisches Störfeld, welches von außen auf die Wippschaltvorrichtung einwirken kann, das durch die aus dem Stand der Technik bekannten Wippschaltvorrichtungen mit Halleffekt-Sensoren nicht erkannt und demgemäß auch nicht eliminiert werden kann. Dies lässt undefinierte Schaltzustände entstehen, welche gerade bei den zuvor genannten sicherheitsrelevanten Anwendungen einer Wippschaltvorrichtung, beispielsweise im Bereich von Hubarbeitsbühnen, unerwünschte und gefährliche Auswirkungen haben können.

Weitere Rocker-Switches mit Hall-Sensoren gemäß dem Oberbegriff des Anspruchs 1 sind z.B. in der US 8,570,126 B1 und in der WO 2013/159067 A1 beschrieben.

Ausgehend von diesem Stand der Technik liegt der vorliegenden Erfindung die Aufgabe zugrunde, eine Steuer- und Bedieneinheit mit einer Wippschaltvorrichtung für ein Hubarbeitsbühne, eine mobile Arbeitsmaschine oder eine Baumaschine zu schaffen, welche für sicherheitsrelevante Anwendungen geeignet ist, welche weniger störanfällig ist, und welche im Reparaturfall einfach auszuwechseln ist.

Diese Aufgabe wird durch den Gegenstand der unabhängigen Patentansprüche gelöst, und bevorzugte Ausführungen der Erfindung sind in den Unteransprüchen definiert.

Die vorliegende Erfindung schafft eine Steuer- und Bedieneinheit für eine Hubarbeitsbühne, eine mobile Arbeitsmaschine oder eine Baumaschine, mit zumindest einer Wippschaltvorrichtung, die ein Gehäuse und ein an dem Gehäuse lösbar befestigtes Betätigungselement umfasst, wobei das Betätigungselement in Bezug zu dem Gehäuse um mindestens eine Drehachse bewegbar ist und zumindest zwei Positionselemente umfasst, und wobei an oder in dem Gehäuse zumindest zwei den Positionselementen gegenüberliegende Sensorelemente angeordnet sind, um eine Position und/oder eine Bewegung des Betätigungselements zu detektieren.

Gegenüber dem oben erwähnten Stand der Technik ist die erfindungsgemäße Steuer- und Bedieneinheit vorteilhaft, da zwei Positionselemente innerhalb des Betätigungselements vorgesehen sind, denen zwei Sensorelemente zugeordnet sind, die in dem Gehäuse angeordnet sind, sodass bei einem Schaltvorgang am Ausgang der Sensorelemente unterschiedliche und voneinander unabhängige elektrische Signalwerte vorliegen, auf deren Grundlage eine Position bzw. eine Bewegung des Betätigungselements sicher detektiert werden kann. Ferner ermöglicht die Verwendung der zwei Positionselemente und der zwei Sensorelemente eine Auswertung der unabhängigen Sensorsignale, wodurch beispielsweise die für Sicherheitsanwendungen wichtige sichere und redundante Auswertung eines Schaltvorgangs gewährleistet werden kann. Ein weiterer Vorteil der erfindungsgemäßen Vorrichtung besteht darin, dass Temperaturänderungen nicht oder nur sehr gering auf die Wippschaltvorrichtung Einfluss haben, da diese gleichmäßig auf beide Sensorelemente einwirken, und demgemäß eine gleichmäßige Auswirkung auf die gemessenen Werte haben.

Gemäß Ausführungsbeispielen sind die Sensorelemente und die Positionselemente derart angeordnet, dass die Sensorelemente und die Positionselemente in jeder Position des Betätigungselements voneinander beabstandet sind.

Gemäß Ausführungsbeispielen umfasst die Steuer- und Bedieneinheit einen Rückstellmechanismus zur Bewegung des Betätigungselements aus einer betätigten Position in eine neutrale Position. Der Rückstellmechanismus kann gemäß Ausführungsbeispielen im Bereich der Drehachse des Betätigungselements angeordnet sein. Gemäß Ausführungsbeispielen umfasst der Rückstellmechanismus ein Rückstellelement, beispielsweise in Form eines Rades oder einer Welle, das an dem Gehäuse angeordnet ist, und eine Rückstellelementaufnahme in dem Betätigungselement, wobei das Rückstellelement ausgebildet ist, um das Betätigungselement in die neutrale Position zu bewegen. Gemäß Ausführungsbeispielen kann vorgesehen sein, dass die Rückstellelementaufnahme eine Vertiefung aufweist, in der das Rückstellelement in der neutralen Position des Betätigungselements angeordnet ist, wobei das Rückstellelement bei einer Betätigung des Betätigungselements aus der Vertiefung bewegbar ist, und wobei das Rückstellelement in dem Gehäuse gelagert ist, um an einer betätigten Position des Betätigungselements eine Kraft in Richtung des Betätigungselements zu bewirken, um das Betätigungselement in die Vertiefung zurückzubewegen. Gemäß Ausführungsbeispielen kann vorgesehen sein, dass das Rückstellelement federnd in dem Gehäuse gelagert ist, um bei einer Bewegung aus der Vertiefung in Richtung des Betätigungselements vorgespannt zu sein. Das Rückstellelement kann gemäß Ausführungsbeispielen mittig zwischen den zwei Positionselementen in dem Gehäuse angeordnet sein und die Rückstellelementaufnahme ist in dem Betätigungselement gegenüberliegend zu dem Rückstellelement angeordnet.

Diese Ausgestaltung des Rückstellmechanismus ist vorteilhaft, da hierdurch sichergestellt wird, dass bei einer Nicht-Betätigung des Betätigungselements des Wippschalters bzw. der Wippschaltvorrichtung das Betätigungselement in seine neutrale Position zurückbewegt wird, in der eine Nicht-Betätigung aufgrund der ausgelesenen Sensorsignale erfasst wird. Somit wird bei Loslassen des Wippschalters jegliche Bewegung oder andersartige Betätigung eines Elements der Maschine, beispielsweise eines Arbeitskorbes der Hubarbeitsbühne oder eines Arbeitswerkzeuges einer Baumaschine beendet, wie es insbesondere bei sicherheitsrelevanten Anwendungen erforderlich ist. Ein weiterer Vorteil der erfindungsgemäßen Ausgestaltung des Rückstellmechanismus besteht darin, dass hier eine Konstruktion bereitgestellt wird, die das Zurückführen des Betätigungselements in die neutrale Position unterstützt, insbesondere wird die Rückstellung durch ein einzelnes Element, nämlich das Rückstellelement, bewirkt, welches federnd gelagert sein kann. Der Einsatz mehrerer, gleichwertiger Bauelemente, die auf das Betätigungselement zum Zurückstellen desselben aus unterschiedlichen betätigten Positionen in die neutrale Position einwirken, wird vermieden, und damit die Notwendigkeit mehrere gleiche Bauelemente im Hinblick auf ihre Rückstellkraft zur Sicherstellung der neutralen Position vorzusehen. Dies vermeidet Probleme im Hinblick auf eine unterschiedliche Alterung unterschiedlicher Elemente über die Zeit, die zu einer fehlerhaften Ausrichtung des Betätigungselements bezüglich der ursprünglich definierten neutralen Position führen können, die dann nicht mehr sicher eingenommen wird, wie es im Zusammenhang mit sicherheitsrelevanten Anwendungen aber erforderlich ist. Solche Nachteile werden durch die erfindungsgemäße Ausgestaltung gemäß Ausführungsbeispielen vermieden, da der zentrale Rückstellmechanismus ein Rückstellelement in Form eines Rades aufweist, welches in einer Vertiefung aufgenommen wird. Das Rad kann sich bei einer Betätigung des Schalters aus einer tiefsten Stelle der Ausnehmung in Richtung eines angehobenen Endes des Schalters bewegen, und wird nach dem Schaltvorgang durch eine Federkraft wieder in die Vertiefung zurückgezwungen, sodass eine zuverlässige Bewegung des Schalters in die neutrale Position sichergestellt ist.

Gemäß Ausführungsbeispielen sind die Positionselemente innerhalb des Betätigungselements so angeordnet, dass ein Abstand eines Positionselements zu der Drehachse größer ist als zu einem Rand des Betätigungselements. Vorzugsweise sind die Positionselemente so angeordnet, dass der Abstand eines Positionselements zur Drehachse im Hinblick auf die Möglichkeit der Anordnung der Positionselemente innerhalb des Betätigungselements maximal wird.

Diese Ausgestaltung ist vorteilhaft, da hierdurch bei einer Betätigung des Betätigungselements ein Abstand zwischen einem der Positionselemente und dem Sensorelement einen großen Wert annimmt, wohingegen ein Abstand zwischen dem anderen Sensorelement und dem anderen Positionselement gering wird, sodass die durch die Sensoren erfassten Signale sicher zu unterscheiden sind.

Gemäß Ausführungsbeispielen sind die Positionselemente derart angeordnet, dass sich ein Abstand zwischen den Positionselementen und den jeweils gegenüberliegenden Sensorelementen bei einer Bewegung des Betätigungselements je nach Bewegungsrichtung vergrößert oder verkleinert.

Diese Ausgestaltung ist vorteilhaft, da hierdurch die Abstände zwischen den Sensorelementen und den Positionselementen unterschiedlich sind, und somit eine sichere Unterscheidung der erfassten Signale ermöglicht wird.

Gemäß Ausführungsbeispielen vergrößert oder verkleinert sich die Differenz der Signalwerte der Sensorelemente bei einer Bewegung des Betätigungselements je nach Bewegungsrichtung, wobei es gemäß Ausführungsbeispielen ausreichend ist, dass die Differenz der Signalwerte der Sensorelemente im Wesentlichen proportional zur Position der Betätigungselemente ist. Gemäß Ausführungsbeispielen ist ferner vorgesehen, dass die Signalwerte der Sensorelemente im nicht-betätigten Zustand des Betätigungselements annähernd gleich sind.

Diese Ausgestaltung ist vorteilhaft, da hierdurch eine sichere Erfassung einer Bewegungsrichtung beim Schalten gewährleistet wird.

Gemäß Ausführungsbeispielen umfassen die Positionselemente Magnetfeld-erzeugende Elemente, z.B. Dauermagnete, deren Pole vorzugsweise in Bezug zu den Sensorelementen gleich ausgerichtet sind.

Diese Ausgestaltung ist vorteilhaft, da hierdurch die Steuer- und Bedieneinheit bzw. deren Wippschaltvorrichtung weniger störanfällig gegenüber äußeren Magnetfeldern oder anderen elektrischen bzw. elektromagnetischen Störungen ist. Eine von außen auf die Wippschaltvorrichtung einwirkende Störung wird mit Magnetfeldern der Dauermagnete überlagert und hat demgemäß keinen bzw. nur geringfügigen Einfluss auf die von den Sensorsignalen gemessenen Werte, sodass die erfindungsgemäße Steuer- und Bedieneinheit insbesondere für sicherheitsrelevante Anwendungen im Bereich mobiler Arbeitsmaschinen, beispielsweise Hubarbeitsbühnen, oder im Bereich von Baumaschinen geeignet ist.

Ein wesentlicher Aspekt dieser Ausführungsform besteht darin, dass erstmals ein Wippschalter geschaffen wird, der aufgrund seines Aufbaus eine Fremdmagnetfelderkennung und -handhabung ermöglicht. Im Stand der Technik bekannte Wippschalter, z.B. Hall-Wippschalter, stellen keine solche Funktionalität bereit. Die erfindungsgemäße Fremdmagnetfelderkennung und -handhabung verbessert die Sicherheit, indem unerwünschte Schaltvorgänge verhindert werden bzw. Fehlerzustände erkannt werden. So kommt es in der Praxis regelmäßig zu Situationen, in denen ein Schalter unbeabsichtigt einem Magnetfeld ausgesetzt ist, welches bei bekannten Schaltern zu einer Fehlfunktion bzw. zu einem unbeabsichtigten Auslösen des Schalters führen kann. Beispielsweise kann eine an einer Magnethalterung angeordnete Beleuchtungsvorrichtung (Lampe) durch einen Bediener von einem Maschinenrahmen abgenommen und auf das Bedienpult gelegt werden. Hierdurch wird durch den erfindungsgemäßen Wippschalter kein Schaltvorgang/Maschinenbewegung ausgelöst, da das Störfeld auf beide Sensoren im Wesentlichen gleich wirkt.

Auch Fehlerfälle bzw. Fehlerzustände können erkannt werden, z.B. der Ausfall eines Sensorelementes oder eines Magneten, der sich z.B. gelöst hat, aber auch eine Demontage des gesamten Betätigungsfeldes. In einer solchen Situation sind z.B. die erfassten Ausgangssignale in der Ruheposition unterschiedlich oder liegen unterhalb eines Schwellwertes, woraus auf einen Fehlerzustand geschlossen werden kann. Aufgrund der Möglichkeit, solche Fehlerfälle zu erkennen, erhöht sich die Sicherheit des erfindungsgemäßen Wippschalters gegenüber herkömmlichen Wippschaltern.

Gemäß Ausführungsbeispielen umfassen die Sensorelemente berührungslose Sensoren, wie Halleffekt-Sensoren, induktive, kapazitive oder magnetoresistive Sensoren.

Gemäß Ausführungsbeispielen umfasst das Gehäuse und/oder das Betätigungselement zumindest teilweise Kunststoff, Aluminium oder ein anderes nicht-magnetisches Material.

Diese Ausgestaltung ist vorteilhaft, da hierdurch eine zusätzliche Öffnung innerhalb einer Frontplatte, auf der das Betätigungselement montiert ist, verhindert wird, da das Magnetfeld, das durch die Positionselemente erzeugt wird, aufgrund der nicht-magnetischen Eigenschaft eines Teils des Gehäuses und/oder des Betätigungselements die Sensorelemente erreicht, wodurch diese beispielsweise abgekapselt, also getrennt von dem Betätigungselement innerhalb eines Gehäuses angeordnet sein können. Dies ermöglicht einen separaten Austausch des Betätigungselements, ohne Austausch des Sensormoduls.

Gemäß Ausführungsbeispielen umfasst das Gehäuse ein Gehäuseunterteil und ein Gehäuseoberteil, wobei die Sensorelemente vorzugsweise an dem Gehäuseunterteil angeordnet sind, und das Betätigungselement vorzugsweise an dem Gehäuseoberteil angeordnet ist. Gemäß Ausführungsbeispielen kann das Gehäuseunterteil mit dem Gehäuseoberteil mittels einer oder mehrerer Schrauben oder einer Rastvorrichtung lösbar verbunden sein. Gemäß Ausführungsbeispielen kann vorgesehen sein, dass das Gehäuseunterteil zumindest im Bereich der Sensorelemente wasserdicht und/oder luftdicht ist. Gemäß Ausführungsbeispielen ist das Betätigungselement mittels einer oder mehrerer Schrauben oder einer Rastvorrichtung lösbar an dem Gehäuseoberteil befestigt.

Diese Ausgestaltung der erfindungsgemäßen Steuer- und Bedieneinheit ist vorteilhaft, da hierdurch das Betätigungselement und die Sensorelemente voneinander getrennt sind, sodass diese auch getrennt austauschbar sind. Insbesondere ist es vorteilhaft, dass die Sensorelemente innerhalb des Gehäuseunterteils angeordnet sind, und zwar so, dass diese vor Umgebungseinflüssen geschützt sind, sodass ein Austausch eines Sensormoduls weniger häufig erforderlich ist. Aufgrund der Umgebungsbedingungen ist lediglich ein häufigerer Austausch des Betätigungselements mit den kostengünstigen Elementen in Form der magnetischen Positionsbestimmungselemente, beispielsweise in Form von Dauermagneten erforderlich.

Gemäß Ausführungsbeispielen ist das Gehäuse lösbar an der Steuer- und Bedieneinheit befestigt.

Diese Ausgestaltung ist vorteilhaft, da hierdurch auf einfache Art und Weise im Bedarfsfall auch ein Austausch des Sensormoduls ermöglicht wird.

Gemäß Ausführungsbeispielen der vorliegenden Erfindung wird ferner eine Hubarbeitsbühne, eine mobile Arbeitsmaschine oder eine Baumaschine mit der erfindungsgemäßen Steuer- und Bedieneinheit bereitgestellt.

Nachfolgend werden unter Bezugnahme auf die beiliegenden Zeichnungen bevorzugte Ausführungsbeispiele der vorliegenden Erfindung näher erläutert. Es zeigen:
- Fig. 1: die Darstellung einer Hubarbeitsbühne mit einer Steuer- und Bedieneinheit, welche den erfindungsgemäßen Handsteuergeber aufweist;
- Fig. 2: eine detailliertere Darstellung der in Fig. 1 dargestellten Steuer- und Bedieneinheit;
- Fig. 3: einen Ausschnitt einer Steuer- und Bedieneinheit gemäß einem Ausführungsbeispiel der Erfindung, ähnlich der Steuer- und Bedieneinheit aus Fig. 2;
- Fig. 4: ein Ausführungsbeispiel eines Wippschalters der erfindungsgemäßen Steuer- und Bedieneinheit für eine mobile Arbeitsmaschine oder eine Baumaschine;
- Fig. 5: eine Explosionsdarstellung des in Fig. 4 gezeigten Wippschalters zur Darstellung dessen Innenaufbaus;
- Fig. 6: Draufsichtdarstellungen der Wippschaltvorrichtung gemäß Fig. 4 und Fig. 5, wobei in Fig. 6(a) die Positionselemente in Bezug zur Längsachse der Wippschaltvorrichtung versetzt angeordnet, und wobei in Fig. 6(b) die Positionselemente entlang der Längsachse der Wippschaltvorrichtung angeordnet sind;
- Fig. 7: eine Schnittdarstellung der in Fig. 6(a) dargestellten Wippschaltvorrichtung entlang der Linie A-A;
- Fig. 8: eine Schnittdarstellung der in Fig. 6(b) dargestellten Wippschaltvorrichtung entlang der Linie B-B in Fig. 6(b); und
- Fig. 9: eine Verkippung des Betätigungselements, wobei Fig. 9(a) eine Verkippung des Betätigungselements nach rechts zeigt, und wobei Fig. 9(b) eine Verkippung des Betätigungselements nach links zeigt.

Nachfolgend werden Ausführungsbeispiele der vorliegenden Erfindung unter Bezugnahme auf die beiliegenden Zeichnungen näher erläutert, wobei in den beiliegenden Zeichnungen gleiche oder gleichwirkende Elemente mit den gleichen Bezugszeichen versehen sind.

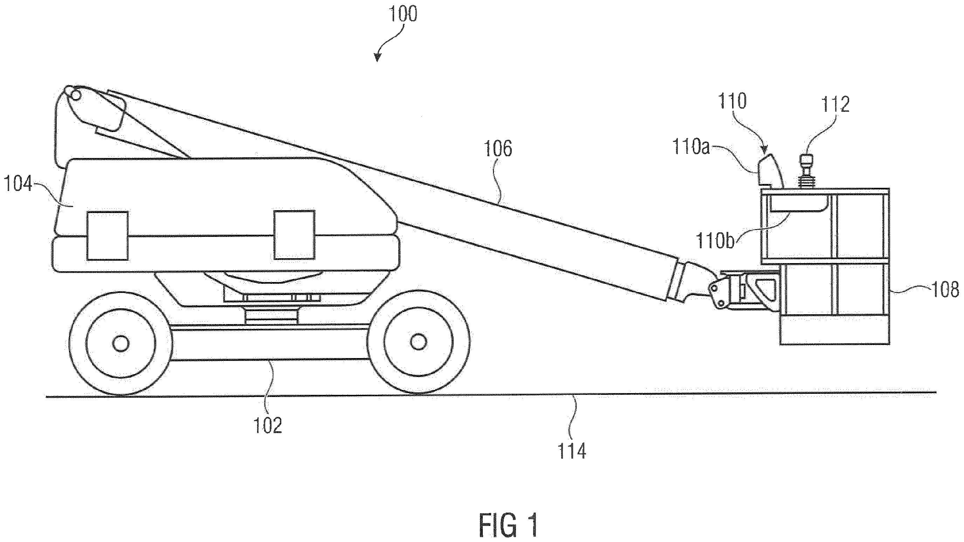

Fig. 1 zeigt die Darstellung einer Arbeitsmaschine bzw. einer Baumaschine mit einer Steuer- und Bedieneinheit, welche den erfindungsgemäßen Handsteuergeber aufweist. Fig. 1 zeigt eine Hubarbeitsbühne 100 mit einem fahrbaren Chassis 102 und einem drehbar auf dem Chassis 102 angeordneten Aufbau 104 der, neben den erforderlichen Motoren zur Bewegung der Hubarbeitsbühne 100, einen Kranmechanismus 106 aufweist, an dessen vorderem Ende eine Arbeitsbühne, z.B. ein Arbeitskorb 108, angeordnet ist. Der Arbeitskorb 108 umfasst eine Steuer- und Bedieneinheit 110, die ihrerseits ein erstes Gehäuseteil 110a, welches im Wesentlichen vertikal orientiert ist, und ein zweites Gehäuseteil 110b aufweist. Die Steuereinheit 110 umfasst ferner einen Handsteuergeber 112, über den die Hubarbeitsbühnen 110 derart gesteuert werden, dass der Arbeitskorb 108 abhängig von einer Bewegungsrichtung des Handsteuergebers 112 bezüglich des Bodens 114 angehoben oder abgesenkt wird. Ebenso wird durch eine entsprechende Betätigung des Handsteuergebers 112 eine Drehung der Hubarbeitsbühne 100 bewirkt.

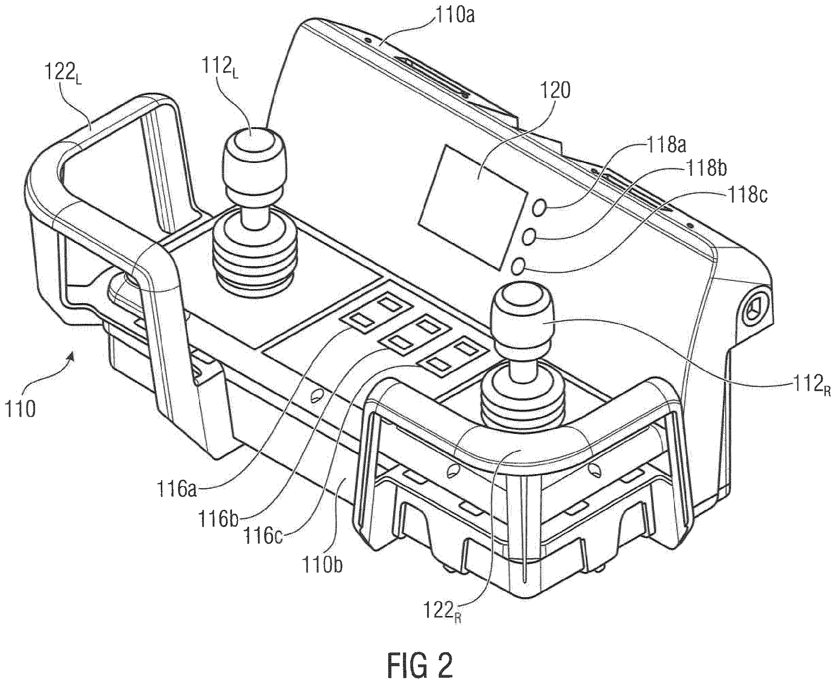

Fig. 2 zeigt eine Darstellung der anhand der Fig. 1 erwähnten Steuer- und Bedieneinheit 110. In den Gehäuseteilen 110a und 110b sind verschiedene Module angeordnet, über die ein Maschinenbediener Werkzeuge und/oder Vorgänge an der Maschine steuern bzw. kontrollieren kann. Zu diesen Modulen zählen beispielsweise ein oder mehrere Wippschalter bzw. Wippschaltvorrichtungen 116a bis 116c, LEDs (lichtemittierende Dioden) 118a bis 118c, eine oder mehrere Anzeigen 120 sowie, bei dem in Fig. 2 gezeigten Beispiel der Steuer- und Bedieneinheit 110, zwei Handsteuergeber, nämlich einen linken Handsteuergeber 112_{L} und einen rechten Handsteuergeber 112_{R}. Details der Wippschalter 116a bis 116c gemäß Ausführungsbeispielen der Erfindung werden nachfolgend unter Bezugnahme auf die weiteren Figuren erläutert. Ferner umfasst die Steuer- und Bedieneinheit 110 die in Fig. 2 dargestellten links- und rechtsseitigen Relings 122_{L} und 122_{R}, die vorgesehen sein können, um die Betätigungseinheiten 120_{L} und 120_{R} vor einer ungewollten Auslenkung zusätzlich zu schützen.

Details eines des in der Fig. 2 dargestellten Wippschalters werden nachfolgend näher erläutert.

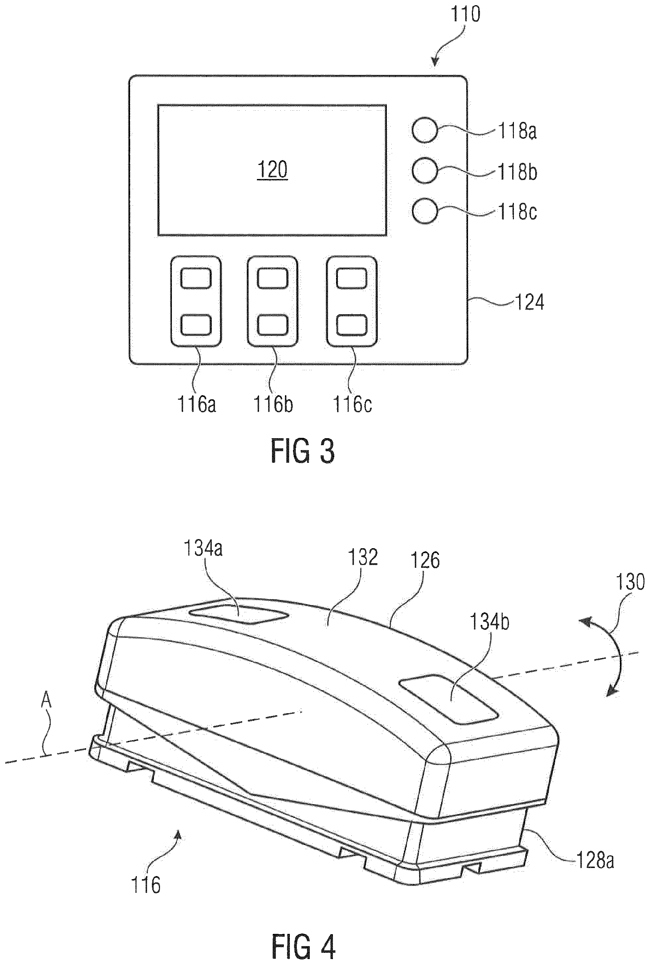

Fig. 3 zeigt einen Ausschnitt einer Steuer- und Bedieneinheit 110 gemäß einem Ausführungsbeispiel der Erfindung, ähnlich der Steuer- und Bedieneinheit aus Fig. 2, allerdings ohne die weiteren Elemente in Form der Betätigungshebel 112_{L} und 112_{R}. Fig. 3 ist eine schematische Darstellung der Steuer- und Bedieneinheit 110, ähnlich dem zentralen Bereich der Einheit aus Fig. 2. Die Steuer- und Bedieneinheit 110 umfasst eine Frontplatte 124, auf der verschiedene Module angeordnet sind, mittels denen ein Maschinenbediener Werkzeuge und/oder Vorgänge an der Maschine steuern bzw. kontrollieren kann. Zu diesen Modulen zählen beispielsweise eine oder mehrere LEDs 118a bis 118c, eine oder mehrere Anzeigen 120 und ein oder mehrere Wippschalter 116a bis 116c, wobei der Aufbau eines solchen Wippschalters nachfolgend im Detail erläutert wird.

Fig. 4 zeigt ein Ausführungsbeispiel eines Wippschalters 116 der erfindungsgemäßen Steuer- und Bedieneinheit für eine mobile Arbeitsmaschine oder eine Baumaschine. Der Wippschalter bzw. die Wippschaltvorrichtung 116 umfasst ein Betätigungselement 126, welches lösbar an einem Gehäuseoberteil 128a eines Gehäuses befestigt ist. Das Betätigungselement 126 ist in Bezug auf das Gehäuse bzw. in Bezug auf das dargestellte Gehäuseoberteil 128a um mindestens eine Achse A bewegbar bzw. verkippbar, wie dies durch den Pfeil 130 in Fig. 4 angedeutet ist. Das Betätigungselement 126 umfasst auf einer Oberfläche 132 zwei Betätigungsfelder 134a und 134b, um einem Bediener eine visuelle und/oder taktile Unterstützung bei der Betätigung der Wippschaltvorrichtung 116 bereitzustellen. Gemäß Ausführungsbeispielen bestehen das Gehäuse und/oder das Betätigungselement 126 zumindest teilweise aus Kunststoff, Aluminium oder einem anderen nicht-magnetischen Material.

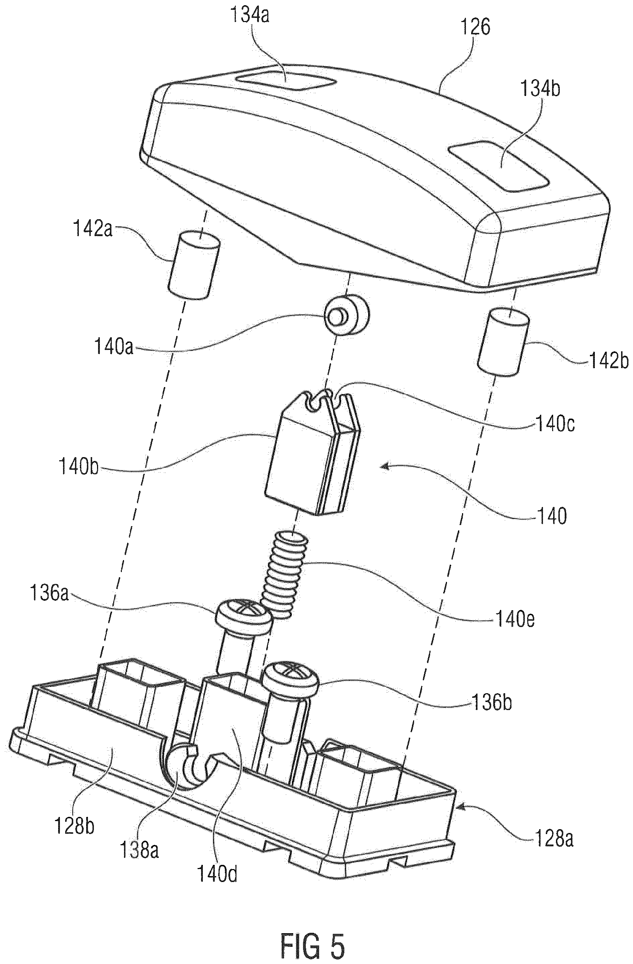

Fig. 5 zeigt eine Explosionsdarstellung des in Fig. 4 gezeigten Wippschalters zur Darstellung dessen Innenaufbaus. Das Gehäuseoberteil 128a ist an einem in Fig. 5 nicht dargestellten Gehäuseunterteil mittels der Schrauben 136a und 136b befestigt. Das Gehäuseoberteil 128a umfasst eine umlaufende Seitenwandung 128b, die im Bereich einer Aufnahme 138a für ein später noch im Detail beschriebenes Rastelement eine Aussparung aufweist. Anstelle der anhand der Fig. 5 erwähnten Schrauben 136a und 136b zur Befestigung des Gehäuseoberteils 128a an einem Gehäuseunterteil kann diese Befestigung gemäß anderen Ausführungsbeispielen auch durch eine Rastvorrichtung erfolgen.

In einem mittleren Bereich des Gehäuseoberteils 128a ist eine bewegbare mechanische Rückstelleinrichtung angeordnet, die in ihrer Gesamtheit mit den Bezugszeichen 140 bezeichnet ist, die eine in Fig. 5 nicht dargestellte, innerhalb des Betätigungselements 126 angeordnete Aufnahme und ein Rückstellelement 140a in Form eines Rades aufweist, welches innerhalb eines Verbindungsstückes 140b drehbar gelagert ist. Das Verbindungsstück 140b umfasst einen Körper, an dessen oberem Ende, welches dem Betätigungselement 126 zugewandt ist, ein Lager 140c zur drehbaren Aufnahme des Rades 140a gebildet ist. Das Verbindungsstück 140b ist innerhalb einer Halterung 140d, die im Wesentlichen mittig im Gehäuseoberteil 128a angeordnet ist, eingefügt. Das Verbindungsstück 140b ist beweglich innerhalb der Halterung 140d angeordnet und wird durch die Halterung 140d derart geführt, dass eine vertikale Bewegung des Verbindungsstückes, also eine Bewegung innerhalb der Halterung 140d in Richtung des Betätigungselements 126 bzw. in Richtung des Gehäuseoberteils 128a ermöglicht ist. Die Rückstelleinrichtung 140 umfasst ferner ein Federelement 140e, welches zwischen einer Unterseite des Verbindungsstücks 140b und dem Gehäuseoberteil 128a angeordnet ist. Gemäß Ausführungsbeispielen ist das Rad 140a und die Feder 140e im oberen Bereich bzw. im unteren Bereich des Verbindungsstücks 140b lösbar angeordnet. Die Rückstelleinrichtung 140 dient dazu, das Betätigungselement 126 in nicht-betätigtem Zustand in einer Mittelposition zu halten, und um nach einer Betätigung und dem Loslassen des Betätigungselements 126 sicherzustellen, dass das Betätigungselement in die Mittelposition bzw. die neutrale Position zurückbewegt wird, wie es nachfolgend noch näher erläutert wird.

Fig. 5 zeigt ferner zwei magnetfelderzeugende Positionselemente 142a und 142b, beispielsweise in Form von Dauermagneten, welche innerhalb des Betätigungselements 126 in entsprechenden, in Fig. 5 nicht dargestellten Halterungen angeordnet sind und sich entsprechend einer Bewegung des Betätigungselements 126 bewegen.

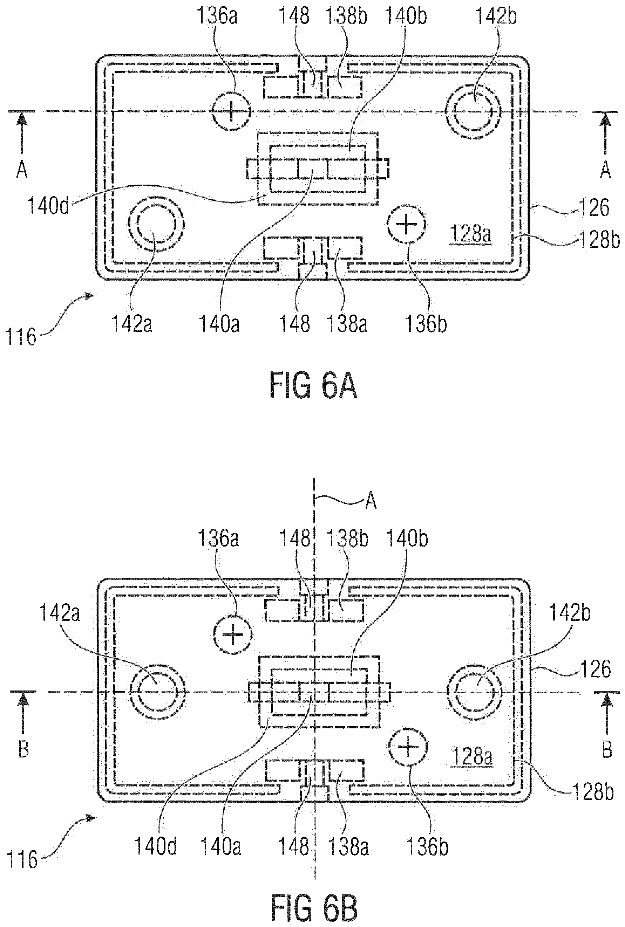

Die Fig. 6(a) und 6(b) zeigen jeweils eine Draufsichtdarstellung der Wippschaltvorrichtung 116 gemäß Fig. 4 und Fig. 5, wobei sich die Darstellungen lediglich im Hinblick auf die Anordnung der Positionselemente 142a und 142b sowie deren Halterungen unterscheiden. In Fig. 6(a) sind die Positionselemente 142a und 142b in Bezug zur Längsachse der Wippschaltvorrichtung 116 versetzt angeordnet, wohingegen in Fig. 6(b) die Positionselemente 142a und 142b entlang der Längsachse (siehe die Linie B-B) der Wippschaltvorrichtung 116 angeordnet sind. Ferner sind in Fig. 6(a) und Fig. 6(b) die Schrauben 136a und 136b zur lösbaren Befestigung des Gehäuseoberteils 128a an einem Gehäuseunterteil dargestellt, wobei die Schrauben in Bezug zur Längsachse der Wippschaltvorrichtung 116 versetzt angeordnet sind. Das Gehäuseoberteil 128a umfasst die zwei Aufnahmen 138a und 138b, und die Seitenumwandung 128b ist im Bereich dieser Aufnahmen ausgespart. Die Aufnahmen 138a und 138b dienen zur Aufnahme von Rastelementen, die jeweils an einem Steg angeordnet ist, der wiederum an einer Seitenwand des Betätigungselements 126 angeordnet ist, wie dies später noch näher erläutert wird. Über die Rastelemente und die zu den Rastelementen korrespondierenden Aufnahmen 138a und 138b ist das Betätigungselement 126 drehbar und lösbar an dem Gehäuseoberteil 128a befestigt.

Im mittleren Bereich des Gehäuseoberteils 128a findet sich die bewegbare, mechanische Rückstelleinrichtung, welche das bereits oben erwähnte, drehbar gelagerte Rad 140a aufweist, welches in eine innerhalb des Betätigungselements 126 angeordnete korrespondierende Aufnahme eingreift, wie dies später noch erläutert wird, sodass das Betätigungselement 126 im nicht-betätigten Zustand in einer Mittelposition oder Neutralposition gehalten wird. Das drehbar gelagerte Rad 140a ist lösbar an dem Verbindungsstück 140b befestigt, welches seinerseits innerhalb der Halterung 140d vertikal beweglich angeordnet ist.

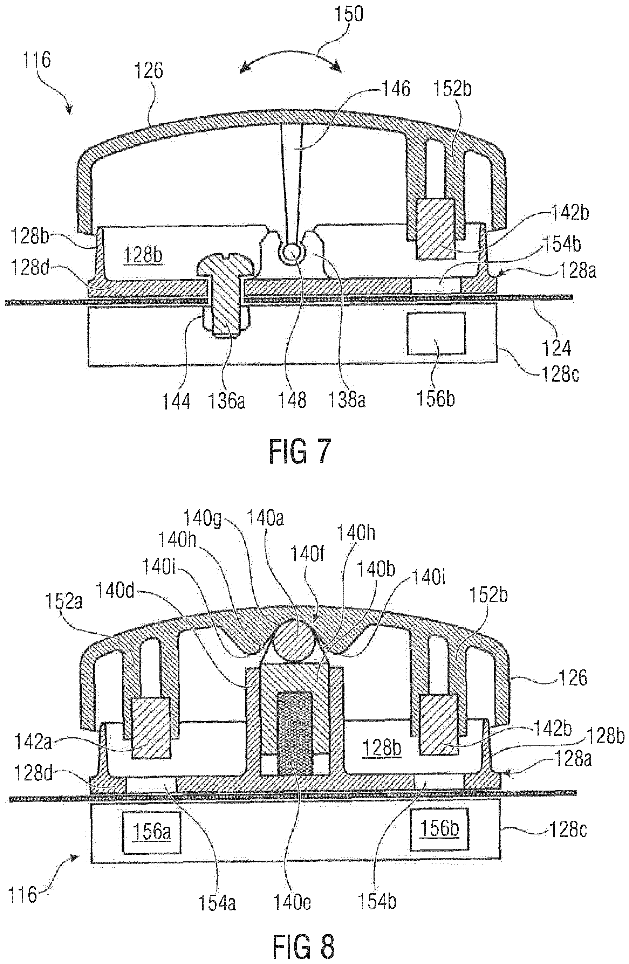

Fig. 7 zeigt eine Schnittdarstellung der in Fig. 6(a) dargestellten Wippschaltvorrichtung 116 entlang der Linie A-A. Zusätzlich zu den anhand der Fig. 5 und 6 bereits erwähnten Elemente zeigt die Fig. 7 die Frontplatte 124 sowie ein Gehäuseunterteil 128c. Das Gehäuseoberteil 128a ist an dem Gehäuseunterteil 128c mittels der Schraube 136a lösbar befestigt, sodass im Reparaturfall das Gehäuseoberteil 128a einfach ausgetauscht werden kann, ohne dass auch das im Regelfall hochwertigere Sensormodul ausgetauscht werden muss. Die Schraube 136a greift durch eine Öffnung im Boden 128d des Gehäuseoberteils 128a sowie durch eine entsprechende Öffnung in der Frontplatte 124 und wird im Gehäuseunterteil 128c durch einen Gewindebolzen 144 gehalten.

Anhand der Fig. 7 wird nun die Befestigung des Betätigungselements 126 an dem Gehäuseoberteil 128a erläutert, wobei in Fig. 7 nur einer der oben erwähnten Mechanismen dargestellt ist. Ein baugleicher Mechanismus ist an der anderen Seite des Wippschalters angeordnet. Das Betätigungselement 126 umfasst einen Steg 146, der an einer Seitenwand oder an einer Innenwand des Betätigungselements 126 befestigt ist, und der sich ausgehend von einer mittleren Position entlang der Längsrichtung der Wippschaltvorrichtung 116 in Richtung des Gehäuseoberteils 128a erstreckt. Am unteren, dem Gehäuseoberteil 128a zugewandten Ende des Stegs 146 ist ein Rastelement 148 angeordnet, welches mit der Aussparung 138a Eingriff nimmt, sodass das Betätigungselement 126 über den Steg 146, das Rastelement 148 und die Aufnahme 138a bewegbar und lösbar an dem Gehäuseoberteil 128a befestigt ist (siehe auch Fig. 6(a) und Fig. 6(b)). Über den Steg 146 ist das Betätigungselement 126 derart beabstandet von dem Gehäuseoberteil 128a angeordnet, dass das Betätigungselement 128a nach links oder rechts (siehe Pfeil 150 in Fig. 7) bewegt werden kann, wie dies später noch näher erläutert wird. Durch die zwei Rastelemente, die entsprechend Ausführungsbeispielen vorgesehen sind, ist die Drehachse A (siehe Fig. 6(b)) des Betätigungselements 126 definiert.

Gemäß Ausführungsbeispielen kann anstelle der Rastvorrichtung zur Befestigung des Betätigungselements 128 auch vorgesehen sein, dieses über eine lösbare Schraubverbindung mit dem Gehäuseoberteil 128a zu verbinden.

Fig. 7 zeigt ferner eine Aufnahme 152b, die in dem Betätigungselement 128 gebildet ist, und in der das Magnetfeld erzeugendes Positionselement 142b angeordnet ist. Eine entsprechende, in Fig. 7 nicht gezeigte Aufnahme für das andere Positionselement 142a ist ebenfalls vorgesehen.

Fig. 7 zeigt ferner, dass unterhalb des magnetischen Positionselements 142b eine Öffnung 154b im Gehäuseoberteil 128a angeordnet ist, in die sich das Positionselement 142b bei einer Bewegung des Betätigungselements 126 hineinbewegt. Ferner befindet sich unterhalb des Positionselements 142b ein im Gehäuseunterteil 128c angeordnetes Sensorelement 156b, welches das Magnetfeld bzw. Magnetfeldänderungen des Positionselements 142b erfasst. Das Sensorelement 156b ist dem Positionselement 142b im Wesentlichen gegenüberliegend angeordnet, um eine Position und/oder eine Bewegung des Betätigungselements 126 anhand des Magnetfelds des Positionselements 142b zu detektieren. Bei dem Sensorelement 156b handelt es sich um einen berührungslosen Sensor, beispielsweise ein Halleffekt-Sensor, einen induktiven Sensor, einen kapazitiven Sensor oder einen magnetoresistiven Sensor. Gemäß Ausführungsbeispielen ist das Gehäuseunterteil 128c zumindest im Bereich des Sensorelements 156b wasserdicht und/oder luftdicht ausgebildet, beispielsweise durch Verfüllen mit einer elektrisch nicht-leitenden Vergussmasse.

Gemäß Ausführungsbeispielen ist im Bereich der Öffnung 154b in der Frontplatte 124 keine zusätzliche Öffnung erforderlich, da die Frontplatte vorzugweise zumindest in diesem Teilbereich aus einem nicht-magnetischen Material besteht, beispielsweise einer Leiterplatte und einer darauf aufgeklebten Frontfolie.

Fig. 8 zeigt eine Schnittdarstellung der in Fig. 6(b) dargestellten Wippschaltvorrichtung 116 entlang der Linie B-B in Fig. 6(b). Anhand der Fig. 8 wird der Aufbau der Rückstelleinrichtung näher erläutert. Ferner zeigt Fig. 8 eine Ausgestaltung, bei der die zwei Positionselemente entlang einer gemeinsamen Längsachse angeordnet sind, und zusätzlich zur Fig. 7 ist das Positionselement 142a sowie das zugeordnete Sensorelement 156a im Gehäuseunterteil 128c gezeigt, ebenso die zusätzliche Öffnung 154a im Boden 128d des Gehäuseoberteils 128b sowie die zusätzliche Halterung 152a im Betätigungselement 126.

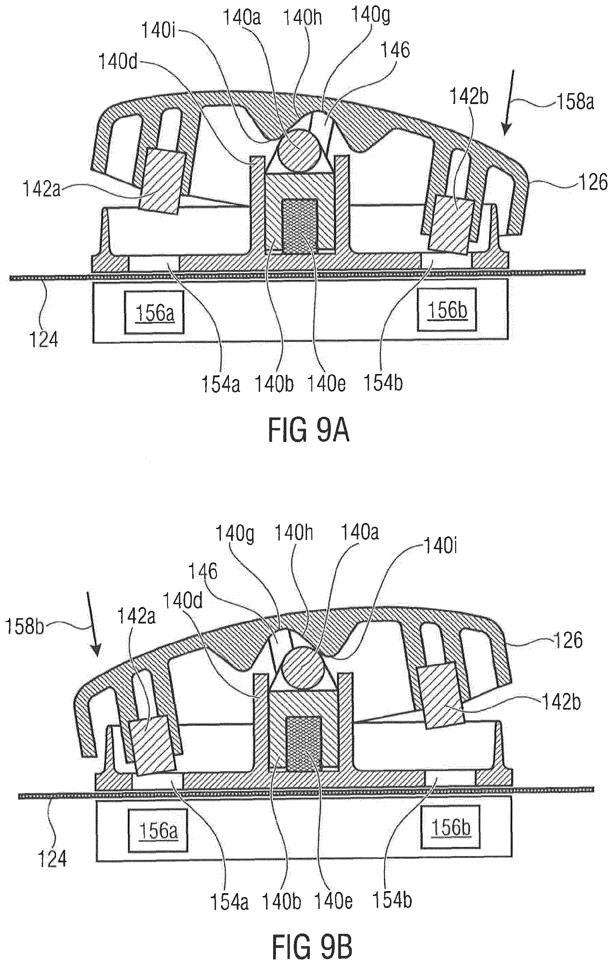

In Fig. 8 ist ferner die Rückstelleinrichtung dargestellt, die das drehbar gelagerte Rad 140a aufweist sowie das in der Halterung 140d vertikal verschiebbar angeordnete Verbindungsstück 140b. Fig. 8 zeigt ferner das Federelement 140e, welches bei dem in Fig. 8 gezeigten Ausführungsbeispiel innerhalb einer Ausnehmung des Verbindungsstücks 140b angeordnet ist, wobei ein dem Gehäuseoberteil 128a benachbartes Ende des Federelements 140e auf dem Boden 128d des Gehäuseoberteils 128a ruht. Bei dem in Fig. 8 dargestellten Ausführungsbeispiel sind die Seitenumwandung 128b, der Boden 128d des Gehäuseoberteils 128b sowie die Halterung 140d einstückig ausgebildet. Der Rückstellmechanismus umfasst ferner eine in dem Betätigungselement 128 angeordnete Rückstellelementaufnahme 140f, in der das Rückstellelement 140a, das drehbar gelagerte Rad, aufgenommen ist. Genauer gesagt umfasst die Aufnahme 140f eine Vertiefung 140g, innerhalb der das Rad 140a in der in Fig. 8 gezeigten neutralen Position oder Mittenposition angeordnet ist. Die Vertiefung 140g umfasst Seitenwände 140a, die sich zu beidseitig der Vertiefung 140g angeordneten Vorsprüngen 140i erstrecken. Eine Verkippung des Betätigungselements 126 nach links oder nach rechts bewirkt eine Bewegung des Rades 140a aus der Vertiefung 140g heraus entlang einer der Seitenflächen 140h in Richtung eines der Vorsprünge 140i, wie dies nachfolgend anhand der Fig. 9(a) und Fig. 9(b) näher erläutert wird.

Fig. 9(a) zeigt eine Verkippung des Betätigungselements 126 nach rechts, beispielsweise durch Ausüben eines Drucks auf das Bedienfeld 134b (siehe Fig. 4 und Fig. 5), wie es in Fig. 9(a) schematisch durch den Pfeil 158a angedeutet ist. Fig. 9(b) zeigt eine Verkippung des Betätigungselements 126 nach links, beispielsweise durch eine Betätigung des Betätigungselements 126 durch Ausüben eines Drucks auf das Bedienfeld 134a (siehe Fig. 4 und Fig. 5), wie es schematisch durch den Pfeil 158b dargestellt ist. Wie aus Fig. 9(a) und Fig. 9(b) zu erkennen ist, bewirkt die Ausübung einer Kraft auf die entsprechenden Bedienelemente ein Verkippen des Betätigungselements 126, wie dies in den Fig. 9(a) und Fig. 9(b) durch die aus der Vertikalen ausgelenkte Position des Steges 146 dargestellt ist, und das Betätigungselement 126 dreht sich um die durch die Rastelemente 148 festgelegte Drehachse nach rechts oder nach links, sodass sich der Abstand der Positionselemente 142a, 142b zu den Sensorelementen 156a, 156b vergrößert bzw. verringert.

Wie aus Fig. 9(a) und Fig. 9(b) ferner zu entnehmen ist, bewirkt das Verkippen des Betätigungselements 126, dass sich das Rad 140a des Rückstellmechanismus 140 entlang der Seitenfläche 140h in Richtung des Vorsprungs 140i bewegt, diesen jedoch nicht erreicht oder überschreitet. Diese Bewegung wird ermöglicht, da das Verbindungsstück 140b innerhalb der Halterung 140d vertikal verschiebbar angeordnet ist. Ein Verkippen des Betätigungselements 126, welches über den Steg 146 mit dem Gehäuse verbunden ist, bewirkt eine Bewegung des Verbindungsstücks 140b entgegen der Federkraft der Feder 140e nach unten in Richtung des Gehäuses innerhalb der Halterung 140d, wodurch eine Bewegung des Rades 140 entlang der Seitenfläche 140h der Vertiefung 140g in Richtung des Vorsprungs 140i ermöglicht wird. Die Dimensionierung des Rückstellmechanismus 140 ist derart gewählt, dass der Vorsprung nicht überschritten wird, vielmehr verbleibt das Rad 140a in der maximal ausgelenkten Stellung des Betätigungselements 126 im Bereich der Seitenfläche 140h. Wird der Druck 158a, 158b nicht länger aufrechterhalten, so bewirkt der Rückstellmechanismus aufgrund der Federkraft der gestauchten Feder 140e, dass sich das Rad 140a entlang der Seitenfläche 140h wieder in die Vertiefung 140g zurückbewegt, um so die ursprüngliche, neutrale Mittenposition gemäß Fig. 8 einzunehmen.

Gemäß Ausführungsbeispielen ist vorgesehen, dass die Positionselemente 142a und 142b innerhalb des Betätigungselements 126 einen maximalen Abstand zu dessen Drehachse aufweisen, indem die Positionselemente 142a, 142b, bzw. deren Halterungen im Betätigungselement soweit wie möglich an den entgegengesetzten Enden entlang der Längsrichtung B-B (siehe Fig. 6(b)) angeordnet werden. Vorzugsweise ist zumindest sicherzustellen, dass der Abstand der Positionselemente 142a, 142b von der Drehachse größer ist als der Abstand zu dem Rand des Betätigungselements. Diese Ausgestaltung ist vorteilhaft, da hierdurch eine Änderung des Abstands zwischen dem Positionselement 142a, 142b und dem gegenüberliegenden Sensorelement 156a, 156b bei einer Bewegung des Betätigungselements 126 so groß wie möglich ist, sodass ein sicherer Schaltzustand der Wippschaltvorrichtung 116 erkannt wird. Gemäß Ausführungsbeispielen sind die Positionselemente 142a, 142b und die beiden Sensorelemente 156a und 156b so angeordnet, dass am Ausgang der Sensorelemente zwei unterschiedliche und voneinander unabhängige elektrische Signalwerte vorliegen, sodass die erfindungsgemäße Steuer- und Bedieneinheit insbesondere für sicherheitsrelevante Anwendungen im Bereich mobiler Arbeitsmaschinen oder Baumaschinen geeignet ist.

Vorzugsweise ist der Abstand der Positionselemente 142a, 142b von den jeweils gegenüberliegenden Sensorelementen 156a, 156b im nicht-betätigten Zustand der Wippschaltvorrichtung 116 (siehe Fig. 8) im Wesentlichen gleich. Hierdurch sind auch die Signalwerte am Ausgang der Sensorelemente 156a und 156b im nicht-betätigten Zustand des Betätigungselements 126 im Wesentlichen gleich. Der Abstand zwischen den Positionselementen 142a, 142b und den jeweils gegenüberliegenden Sensorelementen 156a, 156b vergrößert oder verkleinert sich bei einer Bewegung des Betätigungselements 126 je nach Bewegungsrichtung. Bei einer Bewegung des Betätigungselements 126 vergrößert oder verkleinert sich auch die Differenz der Signalwerte, je nachdem in welche Richtung das Betätigungselements 126 bewegt wird. Vorteilhafterweise verhält sich die Differenz der Signalwerte proportional zur Position des Betätigungselements 126.

Gemäß Ausführungsbeispielen ist das Gehäuseunterteil 128c zumindest im Bereich der Sensorelemente 156a, 156b wasserdicht und/oder luftdicht ausgestaltet, beispielsweise durch Füllen dieses Bereichs des Gehäuses mit einer elektrisch nicht-leitenden Vergussmasse. Eine derart gekapselte Ausführungsform schützt das Gehäuseunterteil 128c mit den darin befindlichen Sensorelementen 158a, 158b vor Umwelteinflüssen, wie beispielsweise Regen oder Staub. Gemäß Ausführungsbeispielen kann das Gehäuseunterteil 128c an der Unterseite der Frontplatte 124 angeklebt, angeschraubt und mittels einer Rastvorrichtung befestigt sein, wobei diese Befestigungsmöglichkeit in den Figuren nicht dargestellt sind.

Im Bereich der Öffnungen 154a, 154b ist in der Frontplatte 124 keine zusätzliche Öffnung notwendig, und die Frontplatte besteht in diesem Bereich vorzugsweise aus einem nicht-magnetischen Material, wie beispielsweise einer Leiterplatte und einer darauf aufgelegten Frontfolie.

Gemäß Ausführungsbeispielen wird bevorzugt, die Pole der Positionselemente bzw. der Dauermagnete 142a, 142b in Bezug zu den Sensorelementen 156a, 156b gleich auszurichten, sodass entweder der Nordpol oder der Südpol der jeweiligen Dauermagnete den Sensorelementen gegenüberliegt. Diese Vorgehensweise ist vorteilhaft, da die erfindungsgemäße Steuer- und Bedieneinheit bzw. deren Wippschaltvorrichtung gemäß einer solchen Ausführungsform weniger störanfällig gegenüber äußeren Magnetfeldern oder anderen elektrischen bzw. elektromagnetischen Störungen ist. Eine von außen auf die Wippschaltvorrichtung 116 einwirkende Störung wird den Magnetfeldern der Positionselemente bzw. der Dauermagnete 142a, 142b überlagert und hat demgemäß keinen bzw. nur einen geringen Einfluss auf die von den beiden Sensorelementen gemessenen Werte. Hierdurch erhöht sich die Eignung der erfindungsgemäßen Steuer- und Bedieneinheit für sicherheitsrelevante Anwendungen im Bereich mobiler Arbeitsmaschinen oder Baumaschinen.

Bei der anhand der Fig. 6(a) dargestellten versetzten Anordnung der Positionselemente 142a, 142b im Betätigungselement 126 in Bezug auf die Längsachse B-B der Wippschaltvorrichtung 116 sind auch die Sensorelemente 156a und 156b entsprechend versetzt anzuordnen. Die versetzte Anordnung der Positions- und Sensorelemente hat den Vorteil, dass beispielsweise die Befestigungsschrauben 136a, 136b so angeordnet werden können, dass diese einen größtmöglichen Abstand zu den Positions- und Sensorelementen aufweisen, und daher keinen oder nur einen geringen Einfluss auf das Magnetfeld der Positionselemente aufweisen, wodurch die Störanfälligkeit der Wippschaltvorrichtung weiter reduziert werden kann.

Der Aufbau der Wippschaltvorrichtung 116 der erfindungsgemäßen Steuer- und Bedieneinheit 10 ermöglicht eine sichere und redundante Auswertung eines Schaltvorgangs, sodass diese Wippschaltvorrichtung in sicherheitsrelevanten Anwendungen, beispielsweise bei Hubarbeitsbühnen, ohne weiteres eingesetzt werden kann.

Anstelle der oben beschriebenen Verwendung von zwei Positionselementen und zwei Sensorelementen kann gemäß weiteren Ausführungsbeispielen vorgesehen sein, zumindest ein weiteres Positionselement und Sensorelement vorzusehen.

Bei den oben beschriebenen Ausführungsbeispielen wurde auf ein Gehäuse Bezug genommen, welches ein Gehäuseoberteil 128a und ein Gehäuseunterteil 128c umfasst. Die vorliegende Erfindung ist nicht auf eine solche Ausgestaltung beschränkt. Gemäß weiteren Ausführungsbeispielen ist kein Gehäuseunterteil vorhanden, so dass das Gehäuse nur das Gehäuseoberteil umfasst. Die Sensorelemente sind z.B. auf der Unterseite einer Leiterplatte angebracht, welche auch als die oben beschriebene Frontplatte dienen kann. Mit anderen Worten kann auch die Leiterplatte als Gehäuseunterteil betrachtet werden kann bzw. das Gehäuseunterteil bilden.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Bezugszeichenliste

- 100: Hubarbeitsbühne
- 102: Chassis
- 104: Aufbau
- 106: Kranmechanismus
- 108: Arbeitskorb
- 110: Steuer- und Bedieneinheit
- 110a,b: Gehäuseteil
- 112: Handsteuergeber
- 114: Boden
- 116a-c: Wippschalter
- 118a-c: LED
- 120: Anzeige
- 122: Reling
- 124: Frontplatte
- 126: Betätigungselement
- 128a: Gehäuseoberteil
- 128b: Umlaufende Seitenwandung des Gehäuseoberteils
- 128c: Gehäuseunterteil
- 128d: Boden des Gehäuseoberteils
- 130: Pfeil
- 132: Oberfläche des Betätigungselements
- 134a,b: Betätigungsfelder
- 136a,b: Schrauben
- 138a,b: Aufnahme
- 140: Rückstelleinrichtung
- 140a: Rückstellelement/Rad
- 140b: Verbindungsstück
- 140c: Lager
- 140d: Halterung
- 140i: Federelement
- 140f: Rückstellelementaufnahme
- 140g: Vertiefung
- 140h: Seitenwand der Vertiefung
- 140i: Vorsprung
- 142a,b: Positionselemente
- 144: Gewindebolzen
- 146: Steg
- 148: Rastelement
- 150: Pfeil
- 152a,b: Positionselementaufnahme
- 154a,b: Öffnung im Gehäuseunterteil
- 156a,b: Sensorelemente

## Patentansprüche

1. Steuer- und Bedieneinheit für eine Hubarbeitsbühne (100), eine mobile Arbeitsmaschine oder eine Baumaschine, mit:
zumindest einer Wippschaltvorrichtung (116), die ein Gehäuse (128a, 128c) und ein an dem Gehäuse (128a, 128c) lösbar befestigtes Betätigungselement (126) umfasst,
wobei das Betätigungselement (126) in Bezug zu dem Gehäuse (128a, 128c) um zumindest eine Drehachse bewegbar ist und zumindest zwei Positionselemente (142a, 142b) umfasst, und
wobei an oder in dem Gehäuse (128a, 128c) zumindest zwei den Positionselementen (142a, 142b) gegenüberliegende Sensorelemente (156a, 156b) angeordnet sind, um eine Position und/oder eine Bewegung des Betätigungselements (126) zu detektieren; und
einem Rückstellmechanismus (140) zur Bewegung des Betätigungselements (126) aus einer betätigten Position in eine neutrale Position,
wobei der Rückstellmechanismus (140) ein Rückstellelement (140a) umfasst, das an dem Gehäuse (128a, 128c) angeordnet ist, wobei das Rückstellelement (140a) ausgebildet ist, um das Betätigungselement (126) in die neutrale Position zu bewegen,
**dadurch gekennzeichnet, dass**
der Rückstellmechanismus (140) eine Rückstellelementaufnahme (140f) in dem Betätigungselement (126) umfasst,
die Rückstellelementaufnahme (140f) eine Vertiefung (140g) aufweist, in der das Rückstellelement (140a) in der neutralen Position des Betätigungselements (126) angeordnet ist, wobei das Rückstellelement (140a) bei einer Betätigung des Betätigungselements (126) aus der Vertiefung (140g) bewegbar ist, und
das Rückstellelement (140a) in dem Gehäuse (128a, 128c) gelagert ist, um in der betätigten Position des Betätigungselements (126) eine Kraft in Richtung des Betätigungselements (126) zu bewirken, um das Betätigungselement (126) in die Vertiefung (140g) zurück zu bewegen, wenn die Betätigung nicht mehr vorliegt.

2. Steuer- und Bedieneinheit nach Anspruch 1, bei der der Rückstellmechanismus (140) im Bereich der Drehachse des Betätigungselements (126) angeordnet ist.

3. Steuer- und Bedieneinheit nach Anspruch 1 oder 2, bei der das Rückstellelement (140a) federnd in dem Gehäuse (128a, 128c) gelagert ist, um bei einer Bewegung aus der Vertiefung (140g) in Richtung des Betätigungselements (126) vorgespant zu sein.

4. Steuer- und Bedieneinheit nach einem der Ansprüche 1 bis 3, bei der das Rückstellelement (140a) mittig zwischen den zwei Positionselementen (142a, 142b) in dem Gehäuse (128a, 128c) angeordnet ist, und bei der die Rückstellelementaufnahme (140f) in dem Betätigungselement (126) gegenüberliegend zu dem Rückstellelement (140a) angeordnet ist.

5. Steuer- und Bedieneinheit nach einem der vorhergehenden Ansprüche, bei der die Positionselemente (142a, 142b) innerhalb des Betätigungselements (126) derart angeordnet sind, das ein Abstand eines Positionselements (142a, 142b) zu der Drehachse größer ist als zu einem Rand des Betätigungselements (126).

6. Steuer- und Bedieneinheit nach einem der vorhergehenden Ansprüche, bei der die Positionselemente (142a, 142b) derart angeordnet sind, dass sich ein Abstand zwischen den Positionselementen (142a, 142b) und den jeweils gegenüberliegenden Sensorelementen (156a, 156b) bei einer Bewegung des Betätigungselements (126) je nach Bewegungsrichtung vergrößert oder verkleinert.

7. Steuer- und Bedieneinheit nach einem der vorhergehenden Ansprüche, bei der sich eine Differenz der Signalwerte der Sensorelemente (156a, 156b) bei einer Bewegung des Betätigungselements (126) je nach Bewegungsrichtung vergrößert oder verkleinert.

8. Steuer- und Bedieneinheit nach einem der vorhergehenden Ansprüche, bei der die Signalwerte der Sensorelemente (156a, 156b) im nicht-betätigten Zustand des Betätigungselements (126) annähernd gleich sind.

9. Steuer- und Bedieneinheit nach einem der vorhergehenden Ansprüche, bei der die Positionselemente (142a, 142b) Dauermagnete umfassen, wobei die Pole der Dauermagnete in Bezug zu den Sensorelementen (156a, 156b) gleich ausgerichtet sind.

10. Steuer- und Bedieneinheit nach einem der vorhergehenden Ansprüche, bei der das Gehäuse (128a, 128c) ein Gehäuseunterteil und ein Gehäuseoberteil umfasst, wobei die Sensorelemente (156a, 156b) in oder an dem Gehäuseunterteil angeordnet sind, und wobei das Betätigungselement (126) an dem Gehäuseoberteil lösbar befestigt ist.

11. Steuer- und Bedieneinheit nach einem der vorhergehenden Ansprüche, bei der das Gehäuse (128a, 128c) lösbar an der Steuer- und Bedieneinheit befestigt ist.

12. Hubarbeitsbühne (100), mobile Arbeitsmaschine oder Baumaschine mit einer Steuer- und Bedieneinheit nach einem der vorhergehenden Ansprüche.

## Claims

1. A control and operating unit for a lifting platform (100), mobile machine or construction equipment, comprising:
at least one rocker switching device (116) comprising a casing (128a, 128c) and an actuating element (126) mounted detachably to the casing (128a, 128c),
wherein the actuating element (126) is moveable relative to the casing (128a, 128c) around at least one rotational axis and comprises at least two position elements (142a, 142b), and
wherein at least two sensor elements (156a, 156b) located opposite the position elements (142a, 142b) are arranged at or in the casing (128a, 128c) in order to detect a position and/or movement of the actuating element (126); and
a reset mechanism (140) for moving the actuating element (126) from an actuated position to a neutral position,
wherein the reset mechanism (140) comprises a reset element (140a) arranged at the casing (128a, 128c), wherein the reset element (140a) is configured to move the actuating element (126) to the neutral position,
**characterized in that**:
the reset mechanism (140) comprises a reset element receptacle (140f) in the actuating element (126),
the reset element receptacle (140f) comprises a recess (140g) where the reset element (140a) is arranged in the neutral position of the actuating element (126), wherein the reset element (140a) is moveable from the recess (140g) when actuating the actuating element (126), and
the reset element (140a) is supported in the casing (128a, 128c) so as to cause, in the actuated position of the actuating element (126), a force directed towards the actuating element (126) in order to move the actuating element (126) back to the recess (140g) when there is no more actuation.

2. The control and operating unit in accordance with claim 1, wherein the reset mechanism (140) is arranged in the region of the rotational axis of the actuating element (126).

3. The control and operating unit in accordance with claim 1 or 2, wherein the reset element (140a) is supported in the casing (128a, 128c) in an elastic manner in order to be biased when moving from the recess (140g) in the direction towards the actuating element (126).

4. The control and operating unit in accordance with any of claims 1 to 3, wherein the reset element (140a) is arranged in the center between the two position elements (142a, 142b) in the casing (128a, 128c), and wherein the reset element receptacle (140f) is arranged in the actuating element (126) opposite the reset element (140a).

5. The control and operating unit in accordance with any of the preceding claims, wherein the position elements (142a, 142b) are arranged within the actuating element (126) such that a distance from a position element (142a, 142b) to the rotational axis is greater than to an edge of the actuating element (126).

6. The control and operating unit in accordance with any of the preceding claims, wherein the position elements (142a, 142b) are arranged such that a distance between the position elements (142a, 142b) and the respective opposite sensor elements (156a, 156b) increases or decreases when moving the actuating element (126), depending on the direction of movement.

7. The control and operating unit in accordance with any of the preceding claims, wherein a difference of the signal values of the sensor elements (156a, 156b) increases or decreases when moving the actuating element (126), depending on the direction of movement.

8. The control and operating unit in accordance with any of the preceding claims, wherein the signal values of the sensor elements (156a, 156b) are approximately equal in the non-actuated state of the actuating element (126).

9. The control and operating unit in accordance with any of the preceding claims, wherein the position elements (142a, 142b) comprise permanent magnets, wherein the poles of the permanent magnets are oriented equally relative to the sensor elements (156a, 156b).

10. The control and operating unit in accordance with any of the preceding claims, wherein the casing (128a, 128c) comprises a casing bottom part and a casing top part, wherein the sensor elements (156a, 156b) are arranged in or at the casing bottom part, and wherein the actuating element (126) is mounted detachably to the casing top part.

11. The control and operating unit in accordance with any of the preceding claims, wherein the casing (128a, 128c) is mounted detachably to the control and operating unit.

12. A lifting platform (100), mobile machine or construction equipment comprising a control and operating unit in accordance with any of the preceding claims.

## Revendications

1. Unité de commande et d'actionnement pour une plate-forme élévatrice (100), une machine de travail mobile ou un engin de chantier, avec:
au moins un dispositif de commutation à bascule (116) comportant un boîtier (128a, 128c) et un élément d'actionnement (126) fixé de manière amovible au boîtier (128a, 128c),
dans lequel l'élément d'actionnement (126) est déplaçable autour d'au moins un axe de rotation par rapport au boîtier (128a, 128c) et comporte au moins deux éléments de position (142a, 142b), et
dans lequel sont disposés, sur ou dans le boîtier (128a, 128c), au moins deux éléments capteurs (156a, 156b) situés opposés aux éléments de position (142a, 142b) pour détecter une position et/ou un déplacement de l'élément d'actionnement (126); et
un mécanisme de rappel (140) destiné à déplacer l'élément d'actionnement (126) d'une position actionnée à une position neutre,
dans lequel le mécanisme de rappel (140) comporte un élément de rappel (140a) qui est disposé sur le boîtier (128a, 128c), dans lequel l'élément de rappel (140a) est conçu pour déplacer l'élément d'actionnement (126) vers la position neutre,
**caractérisé par le fait que**
le mécanisme de rappel (140) comporte un moyen de réception d'élément de rappel (140f) dans l'élément d'actionnement (126),
le moyen de réception d'élément de rappel (140f) présente un évidement (140g) dans lequel l'élément de rappel (140a) est disposé dans la position neutre de l'élément d'actionnement (126), l'élément de rappel (140a) pouvant être déplacé hors de l'évidement (140g) lors d'un actionnement de l'élément d'actionnement (126), et
l'élément de rappel (140a) est monté dans le boîtier (128a, 128c) pour provoquer, dans la position actionnée de l'élément d'actionnement (126), une force en direction de l'élément d'actionnement (126) pour retourner l'élément d'actionnement (126) dans l'évidement (140g) lorsque l'actionnement n'est plus présent.

2. Unité de commande et d'actionnement selon la revendication 1, dans laquelle le mécanisme de rappel (140) est disposé dans la zone de l'axe de rotation de l'élément d'actionnement (126).

3. Unité de commande et d'actionnement selon la revendication 1 ou 2, dans laquelle l'élément de rappel (140a) est monté élastiquement dans le boîtier (128a, 128c) de manière à être précontraint, lors d'un déplacement hors de l'évidement (140g), en direction de l'élément d'actionnement (126).

4. Unité de commande et d'actionnement selon l'une des revendications 1 à 3, dans laquelle l'élément de rappel (140a) est disposé dans le boîtier (128a, 128c) au centre entre les deux éléments de position (142a, 142b), et dans laquelle le moyen de réception d'élément de rappel (140f) est disposé dans l'élément d'actionnement (126) opposé à l'élément de rappel (140a).

5. Unité de commande et d'actionnement selon l'une des revendications précédentes, dans laquelle les éléments de position (142a, 142b) sont disposés à l'intérieur de l'élément d'actionnement (126) de sorte qu'une distance d'un élément de position (142a, 142b) soit supérieure par rapport à l'axe de rotation que par rapport à un bord de l'élément d'actionnement (126).

6. Unité de commande et d'actionnement selon l'une des revendications précédentes, dans laquelle les éléments de position (142a, 142b) sont disposés de sorte qu'une distance entre les éléments de position (142a, 142b) et les éléments capteurs opposées respectifs (156a, 156b) augmente ou diminue lors d'un déplacement de l'élément d'actionnement (126) selon la direction de déplacement.

7. Unité de commande et d'actionnement selon l'une des revendications précédentes, dans laquelle une différence entre les valeurs de signal des éléments de détection (156a, 156b) augmente ou diminue lors d'un déplacement de l'élément d'actionnement (126) selon la direction de déplacement.

8. Unité de commande et d'actionnement selon l'une des revendications précédentes, dans laquelle les valeurs de signal des éléments de détection (156a, 156b) sont, à l'état non actionné de l'élément d'actionnement (126), environ identiques.

9. Unité de commande et d'actionnement selon l'une des revendications précédentes, dans laquelle les éléments de position (142a, 142b) comportent des aimants permanents, où les pôles des aimants permanents sont alignés de manière identique par rapport aux éléments capteurs (156a, 156b).

10. Unité de commande et d'actionnement selon l'une des revendications précédentes, dans laquelle le boîtier (128a, 128c) comporte une partie de boîtier inférieure et une partie de boîtier supérieure, dans laquelle les éléments capteurs (156a, 156b) sont disposés dans ou sur la partie de boîtier inférieure, et dans laquelle l'élément d'actionnement (126) est fixé de manière amovible à la partie de boîtier supérieure.

11. Unité de commande et d'actionnement selon l'une des revendications précédentes, dans laquelle le boîtier (128a, 128c) est fixé de manière amovible à l'unité de commande et d'actionnement.

12. Plate-forme élévatrice (100), machine de travail mobile ou engin de chantier avec une unité de commande et d'actionnement selon l'une des revendications précédentes.
